# EUROPÄISCHE PATENTSCHRIFT

(11) **EP 2 396 223 B1**
(45) Veröffentlichungstag und Bekanntmachung des Hinweises auf die Patenterteilung: **26.08.2015**
(21) Anmeldenummer: 10701016.7
(22) Anmeldetag: 22.01.2010
(51) Int. Cl.: B64D 11/00, H05K 5/02

(54) **WANDHALTERUNG FÜR BORDUNTERHALTUNGS-BEDIENEINHEITEN**
WALL MOUNTING FOR ON-BOARD ENTERTAINMENT CONTROL UNITS
SUPPORT MURAL POUR UNITÉS DE COMMANDE D'APPAREILS DE LOISIR DE BORD

(30) Priorität: 13.02.2009 DE 102009008847; 13.02.2009 US 152362 P
(43) Veröffentlichungstag der Anmeldung: 21.12.2011
(73) Patentinhaber: Airbus Operations GmbH, 21129 Hamburg (DE)
(72) Erfinder: JÄGER, Hartwig, 21635 Jork (DE); HANNA, Klaus, 22769 Hamburg (DE); JEAN-JACQUES, Martin, 22393 Hamburg (DE); RADEKE, Frank, 20099 Hamburg (DE)
(74) Vertreter: Kopf, Korbinian Paul
(86) Internationale Anmeldenummer: PCT/EP2010/050736
(87) Internationale Veröffentlichungsnummer: WO 2010/091935

(56) Entgegenhaltungen:
- WO-A1-2008/014352
- WO-A1-2008/040783
- US-A1- 2004 014 349
- US-B1- 6 702 604

## Beschreibung

### Gebiet der Erfindung

Die Erfindung betrifft die Installation und Halterung für Bordunterhaltungs-Bedieneinheiten eines Flugzeugs. Insbesondere betrifft die Erfindung eine standardisierte Wandhalterung für Bordunterhaltungs-Bedieneinheiten in einer Flugzeugkabine. Ferner betrifft die Erfindung eine Bedieneinheit zur Installation an einer Wandhalterung, ein Bediensystem mit einer Wandhalterung und einer Bedieneinheit, ein Luftfahrzeug mit einem Bediensystem sowie ein Verfahren zum Befestigen einer Bedieneinheit in einer Flugzeugkabine an einer Wand.

### Hintergrund der Erfindung

Bordunterhaltungs (Inflight Entertainment = IFE)-Bedieneinheiten, wie beispielsweise sogenannte RCC Einheiten (bündig montierte Fernbedienungskontrollzentrum, Flush-Mounted Remote Control Center = RCC) können an einem Monument einer Flugzeugkabine befestigt werden, indem sie in die Gewinde einer Grundplatte geschraubt werden, die ihrerseits an dem Monument durch Schrauben befestigt ist. Dabei wird das RCC in Einzelteilen geliefert, die nacheinander auf die Grundplatte geschraubt werden.

Das anzubringende RCC wird dabei in diversen unterschiedlichen Einzelteilen angeliefert und mit mehreren Schrauben an der Grundplatte befestigt. Die Steckverbindung zum Anschließen des RCC an die Flugzeugkabine wird durch separates Stecken und Verschrauben an der Grundplatte befestigt. Die Kabelverlegung innerhalb des Monuments nach der Montage ist oft undefiniert und wird individuell ausgeführt.

Aus der DE102004012262A1 und der US020070063101A1 ist eine Halterung von Kabinenelementen in einem Flugzeug mit einem Halter bekannt.

### Zusammenfassung der Erfindung

Es kann als Aufgabe der Erfindung angesehen werden, ein sicheres, verbessertes und einfacheres Montieren von Bordunterhaltungs-Bedieneinheiten in einer Flugzeugkabine zu ermöglichen.

Es sind eine standardisierte Wandhalterung, eine Bedieneinheit zur Installation an einer Wandhalterung, ein Bediensystem mit einer Wandhalterung und einer Bedieneinheit, ein Luftfahrzeug mit einem Bediensystem und ein Verfahren zum Befestigen einer Bedieneinheit in einer Flugzeugkabine an einer Wand gemäß den Merkmalen der unabhängigen Ansprüche angegeben. Weiterbildungen der Erfindung werden durch die abhängigen Ansprüche verkörpert.

Gemäß einer beispielhaften Ausführung der Erfindung wird eine als Grundplatte ausgeführte standardisierte Wandhalterung für eine Bedieneinheit von Systemkomponenten in einer Flugzeugkabine, wobei die Bedieneinheit einen Stecker und eine Hakenöse aufweist, mit einer Befestigungseinheit, die zum Aufnehmen der Hakenöse der Bedieneinheit ausgeführt ist und wenigstens einer Steckereinheit, in die der Stecker der Bedieneinheit passt, bereitgestellt. Die Befestigungseinheit ist zum Führen der Bedieneinheit bei einer Installationsbewegung der Bedieneinheit an der Wandhalterung ausgeführt. Die Steckereinheit ist zum Bereitstellen einer Steckverbindung zwischen der Bedieneinheit und der Wandhalterung bei der Installationsbewegung der Bedieneinheit an der Wandhalterung ausgeführt.

Eine derartige standardisierte Wandhalterung ermöglicht es, dass eine Bedieneinheit bzw. ein RCC an einem Stück durch die Befestigungseinheit, beispielsweise zentrierende Haken, geführt wird, und senkrecht auf eine als Stecker ausgeführte Steckereinheit, die an der Flugzeugkabine angebracht ist, geschoben werden kann. Der Stecker lässt sich dabei beispielsweise ohne Vorbereitung an eine Grundplatte stecken und lösen, wobei die Grundplatte an der Flugzeugkabine angeordnet ist. Die zentrierenden Haken sind an der Grundplatte, die in U-Form ausgeführt sein kann, angebracht.

Eine derartige standardisierte Wandhalterung ermöglicht es ferner, dass die Bedieneinheit bzw. die RCC direkt durch die Haken auf die Grundplatte gehängt werden kann, und dann lediglich in einer Richtung nach oben fixiert werden muss. Dadurch lässt sich eine beträchtliche Menge an Zeit und Aufwand, beispielsweise in der Endmontagelinie (Final Assembly Line = FAL) bzw. bei dem Flugzeug, einsparen. Ferner ist ein schneller Austausch der Bedieneinheit im Fehlerfall oder bei Systemneuentwicklungen oder Erweiterungen möglich, wodurch eine leichte Rekonfigurierbarkeit bzw. ein Update erfolgen kann.

Eine derartige standardisierte Wandhalterung ermöglicht es weiterhin, das verschiedenste RCC-Modelle, welche lediglich die definierten Halterungen zum Anbringen an den Haken sowie ein Gewinde zum Verschrauben mit der Grundplatte auf der Rückseite aufweisen, auf die Grundplatte befestigt werden können.

Eine derartige standardisierte Wandhalterung stellt ferner einen spezifizierbaren Standard dar, da sich die Position der Haken, der Gewinde in der Grundplatte sowie der Steckereinheit, beispielsweise ausgeführt als RCC-Stecker, klar spezifizieren und standardisieren lassen. Damit kann beispielsweise im Rahmen von Luftfahrzeug Neuentwicklungen eine standardisierte Lösung zur Anbringung unterschiedlich großer RCCs ermöglicht werden. Somit ist die Befestigung des RCCs durch Schrauben, die die RCC-Dimension auf genau eine passende Ausführung beschränken, nicht mehr notwendig. Ferner müssen so beispielsweise bei einem größeren RCC-Monitor, der sich nicht teilen lässt, die Gewinde zur Monitorbefestigung nicht durch umgefalzte Seiten an der Grundplatte, die ein Ausschlusskriterium bei der Skalierung darstellen würden, verdeckt werden. Die Verkleidung der Bedieneinheit erfolgt durch einen Verkleiderahmen, der an der Bedieneinheit angebracht wird, wie im Folgenden gezeigt wird.

Eine derartige standardisierte Wandhalterung erleichtert ferner die Zusammenarbeit von Bordküchen (Galley) und Bordunterhaltungs (IFE) Lieferanten. Durch den einheitlichen Standard, welcher beiden Lieferanten bekannt ist, können beide Lieferanten ohne große Absprachen ihren Teil fertigen. Die toleranzgenauen, nach dem Standard gefertigten Teile, können dadurch exakt zu- und ineinander passen. Entwicklungskosten bleiben beispielsweise beim Flugzeughersteller und dem Lieferanten aus. Ferner lassen sich ebenfalls die Stückkosten reduzieren, falls immer derselbe Standard gefertigt wird.

Eine derartige standardisierte Wandhalterung ermöglicht es ferner, dass höhere Toleranzgenauigkeiten erzielt werden können, da der Stecker sowie das Gewinde zur RCC-Befestigung auf der Grundplatte untergebracht sind, anstatt dass der Stecker und das Gewinde sich einzeln auf der Grundplatte befinden, die an einem an einer Flugzeugkabine angebrachten Monument durch Schrauben befestigt ist.

Gemäß einem weiteren Ausführungsbeispiel der Erfindung ist die Steckereinheit als Stecker oder Steckdose ausgeführt, wobei die Steckdose an der Grundplatte befestigt ist, und wobei der Stecker entweder an der Bedieneinheit integriert ausgeführt ist oder als separates Teil bei der Installation der Bedieneinheit an der Wandhalterung zwischen der Steckdose und der Bedieneinheit in die Steckdose eingesetzt wird.

Gemäß einem weiteren Ausführungsbeispiel der Erfindung kann die standardisierte Wandhalterung zwei oder mehrere Befestigungseinheiten aufweisen.

Gemäß einer weiteren beispielhaften Ausführung der Erfindung weist die Wandhalterung ferner eine Grundplatte auf, wobei die Grundplatte zur Anbringung der Wandhalterung an der Flugzeugkabine ausgeführt ist, wobei die Steckereinheit an die Grundplatte montiert ist.

Gemäß einem weiteren Ausführungsbeispiel der Erfindung ist die Befestigungseinheit an der Grundplatte anbringbar.

Gemäß einem weiteren Ausführungsbeispiel der Erfindung weist die Wandhalterung ferner ein Monument auf, wobei das Monument an der Flugzeugkabine angebracht ist, wobei die Grundplatte zum Befestigen an dem Monument durch Schrauben ausgeführt ist.

Gemäß einem weiteren Ausführungsbeispiel der Erfindung weist die Wandhalterung weiterhin wenigstens einen Führungsbolzen auf, wobei die Steckereinheit zur Positionierung der Steckereinheit durch den Führungsbolzen ausgeführt ist.

Eine derartige Wandhalterung mit einer Steckereinheit mit wenigstens einem Führungsbolzen ermöglicht es, dass die als Stecker ausgeführte Steckereinheit ohne eine Verschraubung auskommt und sich selbst durch Führungsbolzen zentriert.

Gemäß einem weiteren Ausführungsbeispiel der Erfindung ist die Steckereinheit zum lösbaren Anbringen an der Grundplatte ausgeführt.

Gemäß einem weiteren Ausführungsbeispiel der Erfindung weist die Wandhalterung weiterhin wenigstens ein Gewinde auf, wobei das Gewinde zum Befestigen der Bedieneinheit an der Wandhalterung ausgeführt ist.

Gemäß einem weiteren Ausführungsbeispiel der Erfindung ist das Gewinde an der Grundplatte angeordnet.

Gemäß einem weiteren Ausführungsbeispiel der Erfindung weist die Wandhalterung ferner einen Verkleidungsrahmen auf, wobei der Verkleidungsrahmen zum Verkleiden der Bedieneinheit an der Bedieneinheit mittels einer Schnappverbindung ausgeführt ist. Der Anklickmechanismus kann beispielsweise durch einen federbelasteten Schnappverschluss oder durch jeglichen Schnappverschluss ausgeführt sein.

Gemäß einem weiteren Ausführungsbeispiel der Erfindung weist die Wandhalterung ferner einen Rahmen auf, wobei der Rahmen auf die Grundplatte durch einen Schnappverschluss anbringbar ausgeführt ist, wobei der Rahmen zum Befestigen der Bedieneinheit ausgeführt ist, wobei der Rahmen zum Ausrichten der Bedieneinheit in eine horizontale Richtung und eine vertikale Richtung ausgeführt ist, nachdem die Installationsbewegung der Bedieneinheit durchgeführt ist.

Gemäß einem weiteren Ausführungsbeispiel der Erfindung ist der Schnappverschluss als ein federbelasteter Schnappverschluss ausgeführt.

Gemäß einem weiteren Ausführungsbeispiel der Erfindung wird eine Bedieneinheit für Systemkomponenten in einer Flugzeugkabine zur Installation an einer Wandhalterung nach einem der vorhergehenden Ausführungsbeispiele bereitgestellt.

Gemäß einem weiteren Ausführungsbeispiel ist die Bedieneinheit unterhalb eines Monitors der Bedieneinheit zum Fixieren auf die Grundplatte durch wenigstens eine Schraube ausgeführt ist.

Gemäß einem weiteren Ausführungsbeispiel kann die Bedieneinheit unterhalb des Monitors der Bedieneinheit durch mehrere Schrauben auf eine Grundplatte fixiert werden.

Gemäß einem weiteren Ausführungsbeispiel der Erfindung wird ein Bediensystem zur Bedienung von Bordunterhaltungseinheiten in einer Flugzeugkabine mit einer Wandhalterung nach einem der vorhergehenden Ausführungsbeispiele sowie einer Bedieneinheit nach einem der vorhergehenden Ausführungsbeispiele angegeben.

Gemäß einem weiteren Ausführungsbeispiel wird ein Luftfahrzeug mit einem Bediensystem nach dem vorherigen Ausführungsbeispiel bereitgestellt.

Gemäß einem weiteren Ausführungsbeispiel der Erfindung ist ein Verfahren zum Befestigen einer Bedieneinheit von Systemkomponenten in einer Flugzeugkabine an einer Wand mit den folgenden Schritten angegeben, bei dem ein Positionieren der Bedieneinheit in einer ersten Position relativ zu einer Wandhalterung, ein Führen der Bedieneinheit durch eine Befestigungseinheit der Wandhalterung von der ersten Position in eine zweite Position und ein Herstellen einer Steckverbindung zwischen der Bedieneinheit und der Wandhalterung und einer Fixierung der Bedieneinheit durch die Bewegung der Bedieneinheit von der ersten Position in die zweite Position erfolgen.

Gemäß einem weiteren Ausführungsbeispiel der Erfindung weist das Verfahren zum Befestigen einer Bedieneinheit von Systemkomponenten in einer Flugzeugkabine an einer Wand weiterhin ein Befestigen der Bedieneinheit an der Wandhalterung durch Anbringen eines Rahmens an die Wandhalterung auf.

Die einzelnen Merkmale der verschiedenen Ausführungsbeispiele können selbstverständlich auch untereinander kombiniert werden, wodurch sich zum Teil auch vorteilhafte Wirkungen einstellen können, die über die Summe der Einzelwirkungen hinausgehen, selbst wenn diese nicht ausdrücklich beschrieben sind.

Es ist insbesondere zu beachten, dass die hier und im Folgenden im Hinblick auf die standardisierte Wandhalterung beschriebenen Merkmale auch in dem Verfahren, dem Luftfahrzeug, dem Bediensystem und der Bedieneinheit implementierbar sind und umgekehrt.

Diese und andere Aspekte der Erfindung werden durch die Bezugnahme auf die hiernach beschriebenen beispielhaften Ausführungsformen erläutert und verdeutlicht.

Kurze Beschreibung der Zeichnungen
- Fig. 1a: zeigt eine schematische Darstellung eines Bediensystems zum Bedienen von Bordunterhaltungseinheiten in einer Flugzeugkabine mit einer standardisierten Wandhalterung und einer Bedieneinheit gemäß einem Ausführungsbeispiel der Erfindung.
- Fig. 1b: zeigt eine weitere schematische Darstellung des Bediensystems der Fig. 1a.
- Fig. 1c: zeigt eine schematische seitliche Schnittansicht des Bediensystems der Fig. 1a.
- Fig. 2a: zeigt eine perspektivische schematische Darstellung des Bediensystems zum Bedienen von Bordunterhaltungseinheiten in einer Flugzeugkabine mit einer standardisierten Wandhalterung und einer Bedieneinheit gemäß einem Ausführungsbeispiel der Erfindung.
- Fig. 2b: zeigt eine schematische Vorderansicht des Bediensystems der Fig. 2a.
- Fig. 3a: zeigt eine perspektivische Darstellung einer standardisierten Wandhalterung gemäß einem Ausführungsbeispiel der Erfindung.
- Fig. 3b: zeigt eine schematische Draufsicht der standardisierten Wandhalterung der Fig. 3a.
- Fig. 3c: zeigt eine schematische Schnittansicht von der Seite von der standardisierten Wandhalterung der Fig. 3a.
- Fig. 3d: zeigt eine schematische Schnittansicht von oben von der standardisierten Wandhalterung der Fig. 3a.
- Fig. 4a: zeigt eine schematische perspektivische Darstellung eines Verkleidungsrahmens gemäß einem Ausführungsbeispiel der Erfindung.
- Fig. 4b: zeigt eine schematische Draufsicht des Verkleidungsrahmens der Fig. 4a.
- Fig. 4c: zeigt eine schematische Schnittansicht von der Seite von dem Verkleidungsrahmen der Fig. 4a.
- Fig. 4d: zeigt eine schematische Schnittansicht von oben von dem Verkleidungsrahmen der Fig. 4a.
- Fig. 5a: zeigt eine schematische perspektivische Ansicht von einem Bediensystem zum Bedienen von Bordunterhaltungseinheiten in einer Flugzeugkabine mit einer standardisierten Wandhalterung und einer Bedieneinheit gemäß einem Ausführungsbeispiel der Erfindung.
- Fig. 5b: zeigt eine schematische Draufsicht des Bediensystems der Fig. 5a.
- Fig. 5c: zeigt eine schematische Schnittansicht von der Seite von der standardisierten Wandhalterung der Fig. 5b entlang der Schnittlinie A-A der Fig. 5b.
- Fig. 5d: zeigt eine schematische Schnittansicht von der Seite von dem Rahmen zum Befestigen der Bedieneinheit der Fig. 5b.
- Fig. 6a: zeigt eine weitere schematische Draufsicht der standardisierten Wandhalterung der Fig. 5b.
- Fig. 6b: zeigt eine schematische seitliche Schnittansicht der standardisierten Wandhalterung der Fig. 6a.
- Fig. 7a: zeigt eine schematische Draufsicht eines Bediensystems zum Bedienen von Bordunterhaltungseinheiten in einer Flugzeugkabine mit einer standardisierten Wandhalterung und einer Bedieneinheit gemäß einem Ausführungsbeispiel der Erfindung.
- Fig. 7b: zeigt eine seitliche Schnittansicht des Rahmens zum Befestigen der Bedieneinheit der Fig. 7a.
- Fig. 7c: zeigt eine seitliche Schnittansicht des Rahmens zum Befestigen der Bedieneinheit der Fig. 7a entlang der Schnittlinie B-B der Fig. 7a.
- Fig. 8: zeigt eine schematische Darstellung eines Luftfahrzeugs mit einem Bediensystem gemäß einem Ausführungsbeispiel der Erfindung.
- Fig. 9: zeigt ein Flussdiagramm eines Verfahrens zum Befestigen einer Bedieneinheit von Systemkomponenten in einer Flugzeugkabine an einer Wand gemäß einem Ausführungsbeispiel der Erfindung.

### Detaillierte Beschreibung beispielhafter Ausführungsformen

Im Folgenden werden unter Bezugnahme auf die beigefügten Zeichnungen Ausführungsbeispiele der Erfindung beschrieben.

Die Darstellungen in den Figuren sind schematisch und nicht maßstäblich. In den folgenden Figurenbeschreibungen werden für gleiche oder ähnliche Elemente die gleichen Bezugszeichen verwendet.

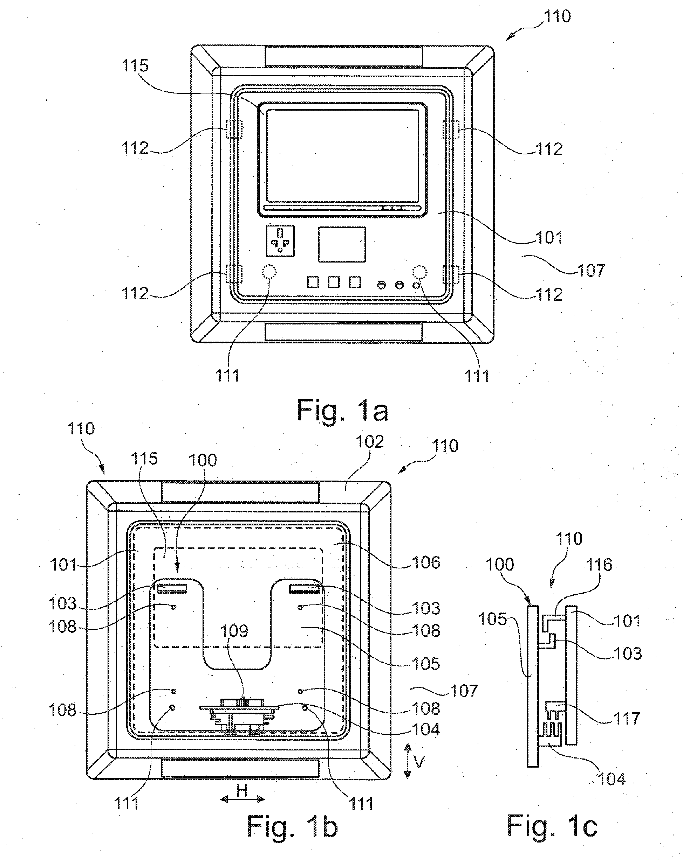

Fig. 1a zeigt ein Bediensystem 110 zum Bedienen von Bordunterhaltungseinheiten in einer Flugzeugkabine 107 mit einer Bedieneinheit 101, die über zwei Gewinde 111 an einer Grundplatte 105 (siehe Fig. 1b) mit Schrauben befestigt ist. Ein Verkleidungsrahmen 102 ist über einen Clipmechanismus 112 an der Bedieneinheit 101 anklickbar. Die Bedieneinheit 101 weist einen Monitor 115 auf.

Fig. 1b zeigt das Bediensystem 110 mit einer Wandhalterung 100. Die Bedieneinheit 101 mit dem Monitor 115 ist gestrichelt dargestellt. Die standardisierte Wandhalterung 100 ist als U-förmige Grundplatte 105 mit zwei Befestigungseinheiten 103 ausgeführt. Die Befestigungseinheiten 103 sind als zwei Haken ausgeführt. Die Grundplatte 105 weist ferner mehrere Gewinde 108 zum Befestigen der Grundplatte 105, beispielsweise an der Wand einer Flugzeugkabine 107, auf.

Ferner weist die Grundplatte 105 zwei Gewinde 111 zum Befestigen der Bedieneinheit 101 an der Grundplatte 105 durch Schrauben auf.

Eine Steckereinheit 104 ist senkrecht zur Grundplatte 105 angebracht und wird durch einen Führungsbolzen 109 positioniert bzw. zentriert.

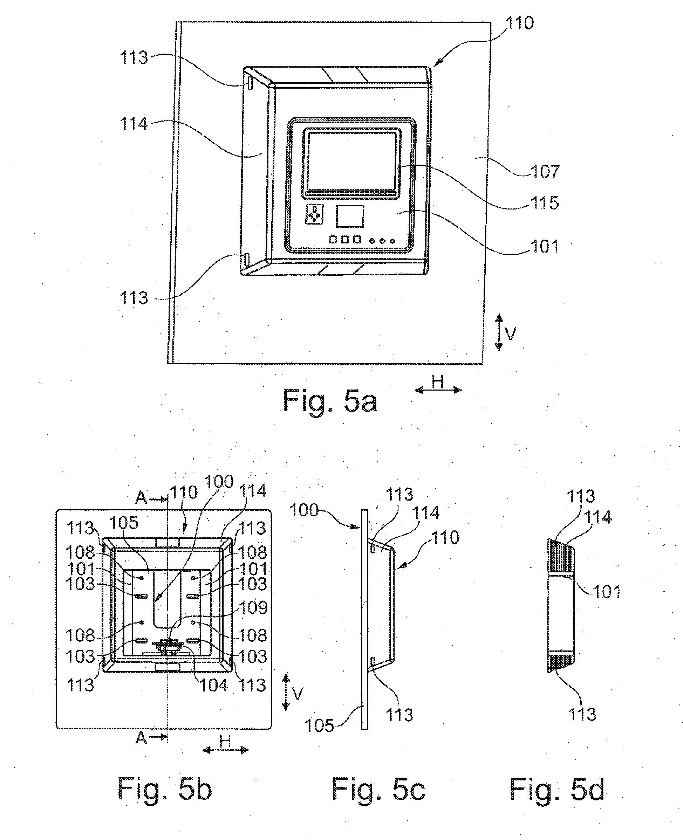

In Fig. 1b wird ferner ein Verkleidungsrahmen 102 zum Verkleiden der Bedieneinheit 101 gezeigt. Der Verkleidungsrahmen 102 ist auch als Rahmen 114 (siehe Fig. 5a bis Fig. 7c) ausführbar, der auf der Grundplatte 105 durch einen Schnappverschluss 113 (siehe Fig. 5a bis Fig. 7c) anbringbar ist und zum Befestigen der Bedieneinheit 101 ausgeführt ist, wobei der Rahmen 114 zum Ausrichten der Bedieneinheit 101 in eine horizontale Richtung H und eine vertikale Richtung V ausgeführt ist, wie in Fig. 1b gezeigt wird.

Ein Monument 106 ist an der Flugzeugkabine 107 angebracht, wobei die Grundplatte 105 an dem Monument 106 durch Schrauben befestigt werden kann, die in die Gewinde 108 der Grundplatte 105 eingreifen.

Fig. 1c zeigt eine seitliche Schnittansicht des Bediensystems 110 der Fig. 1a mit einer als Grundplatte 105 ausgeführten standardisierten Wandhalterung 100 mit Befestigungseinheiten 103, die als Haken ausgeführt sind, sowie mit einer Steckereinheit 104, die als Steckdose ausgeführt ist. Das Bediensystem 110 weist ferner eine Bedieneinheit 101 mit einem Stecker 117 und einer Hakenöse 116 auf. Die Hakenöse 116 ist zur Aufnahme an der Befestigungseinheit 103 der Wandhalterung 100 ausgeführt. Der Stecker 117, der an der Bedieneinheit 101 angebracht ist, passt in die Steckdose der Wandhalterung 100.

Bei einer Installation der Bedieneinheit 101 an der Wandhalterung 100 werden die Ösen 116 der Bedieneinheit 101 durch Befestigungseinheiten 103 der Wandhalterung 100 geführt, wobei gleichzeitig der Stecker 117 der Bedieneinheit 101 in die als Steckdose ausgeführte Steckereinheit 104 der als Grundplatte 105 ausgeführten Wandhalterung 100 eingesetzt oder gesteckt.

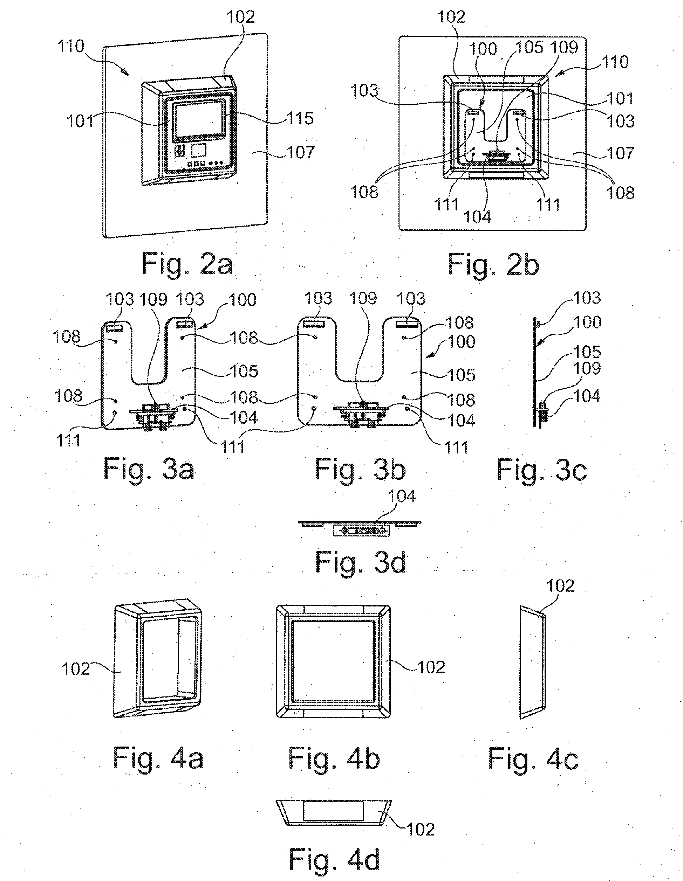

Fig. 2a zeigt eine perspektivische Ansicht eines Bediensystems 110 gemäß Fig. 1a mit einem Verkleidungsrahmen 102 zum Verkleiden einer Bedieneinheit 101, die einen Monitor 115 aufweist. Das Bediensystem 110 ist in einer Flugzeugkabine 107 angeordnet.

Fig. 2b zeigt eine Draufsicht des Bediensystems 110 gemäß Fig. 2a mit einem Verkleidungsrahmen 102 zum Verkleiden der Bedieneinheit 101 und einer standardisierten Wandhalterung 100 mit zwei Haken 103 bzw. Befestigungseinheiten 103 zum Führen der Bedieneinheit 101 bei einer Installation der Bedieneinheit 101 an der Wandhalterung 100. Fig. 2b zeigt ebenfalls eine Steckereinheit 104, die an einer Grundplatte 105 angebracht ist, und die zum Bereitstellen einer Steckverbindung zwischen der Bedieneinheit 101 und der Wandhalterung 100 bei einer Installation der Bedieneinheit 101 an der Wandhalterung 100 ausgeführt ist.

Ferner zeigt Fig. 2b einen Führungsbolzen 109, wobei die Steckereinheit 104 zur Positionierung der Steckereinheit 104 durch den Führungsbolzen 109 ausgeführt ist.

Die Gewinde 108 sind zum Befestigen der Grundplatte 105 an der Flugzeugkabine 107 durch Schrauben ausgeführt. Die standardisierte Wandhalterung 100 weist ferner zwei Gewinde 111 auf, wobei die Gewinde 111 zum Befestigen der Bedieneinheit 101 an der als Grundplatte 105 ausgeführten Wandhalterung 100 ausgeführt ist.

Fig. 3a zeigt eine perspektivische Darstellung der standardisierten Wandhalterung 100 gemäß Fig. 2b, mit den Elementen der Wandhalterung 100, wie sie in Fig. 2b beschrieben sind.

Fig. 3b zeigt eine Draufsicht der Wandhalterung 100 gemäß Fig. 3a mit allen Elementen der Wandhalterung 100, wie sie in Fig. 3a beschrieben sind.

Fig. 3c zeigt eine seitliche Schnittansicht der standardisierten Wandhalterung 100 mit einer Befestigungseinheit 103, die als Haken ausgeführt sein kann, sowie einem Führungsbolzen 109 zum Positionieren einer Steckereinheit 104.

Fig. 3d zeigt eine schematische Schnittansicht der Wandhalterung mit einer Steckereinheit 104 von oben.

Fig. 4a zeigt eine schematische perspektivische Darstellung.eines Verkleidungsrahmens 102 zum Verkleiden einer Bedieneinheit 101 (nicht gezeigt) durch Anklicken.

Fig. 4b zeigt eine Draufsicht des Verkleidungsrahmens 102 gemäß Fig. 4a.

Fig. 4c zeigt eine seitliche Schnittansicht des Verkleidungsrahmens 102 gemäß Fig. 4b.

Fig. 4d zeigt eine seitliche Draufsicht des Verkleidungsrahmens 102 gemäß Fig. 4b.

Fig. 5a zeigt eine perspektivische Darstellung eines Bediensystems 110 zum Bedienen von Bordunterhaltungseinheiten in einer Flugzeugkabine 107 mit einer Bedieneinheit 101, die durch einen Rahmen 114, der mittels federbelasteten Schnappverschlüssen 113 an eine Grundplatte 105 (nicht gezeigt) geklickt wird, in alle Richtungen an einer Wand einer Flugzeugkabine 107 fixiert wird. Die Bedieneinheit 101 weist einen Monitor 115 auf.

Fig. 5b zeigt eine schematische Draufsicht auf das Bediensystem 110 gemäß Fig. 5a, mit einer Bedieneinheit 101, die durch Befestigungseinheiten 103, die als Haken ausgeführt sein können, bei einer Installation der Bedieneinheit 101 an der standardisierten Wandhalterung 100 geführt wird und durch eine Steckverbindung zwischen der Bedieneinheit 101 und der Wandhalterung 100 bei einer Installation der Bedieneinheit 101 an der standardisierten Wandhalterung 100 befestigt wird.

Fig. 5b zeigt ebenfalls einen Führungsbolzen 109, der die Steckereinheit 104 positioniert bzw. zentriert. Die standardisierte Wandhalterung 100 ist als U-förmige Grundplatte 105 ausgeführt, die Gewinde 108 aufweist, die zum Befestigen der Grundplatte mit Schrauben an einer Flugzeugkabine 107 oder ein Monument, das an einer Flugzeugkabine 107 befestigt ist, ausgeführt sind.

In Fig. 5b wird ferner ein Rahmen 114 gezeigt, der auf die Grundplatte 105 durch mehrere Schnappverschlüsse 113 anbringbar ausgeführt ist, wobei der Rahmen 114 die Bedieneinheit 101 befestigt und in einer horizontalen Richtung H und einer vertikalen Richtung V ausrichtet.

Fig. 5c zeigt eine seitliche Schnittansicht des Bediensystems 110 gemäß Fig. 5b mit einer Wandhalterung 100, die als Grundplatte 105 ausgeführt ist, und an der ein Rahmen 114 über Schnappverschlüsse 113 geklickt ist.

Fig. 5d zeigt eine seitliche Schnittansicht des Rahmens 113 zum Befestigen der Bedieneinheit 101 mit Schnappverschlüssen 113 sowie der Bedieneinheit 101 entlang der Schnittlinie A-A gemäß Fig. 5b.

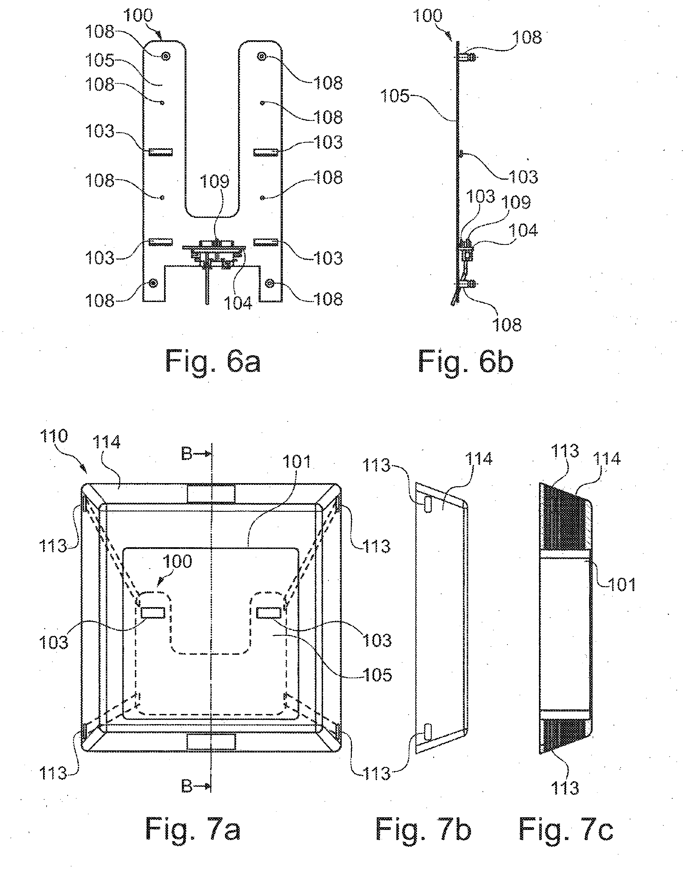

Fig. 6a zeigt eine standardisierte Wandhalterung 100 mit allen Elementen gemäß dem Ausführungsbeispiel, das in Fig. 5b gezeigt wird.

Fig. 6b zeigt eine seitliche Schnittansicht der Wandhalterung 100 gemäß Fig. 6a mit Befestigungseinheiten 103, die als Haken ausgeführt sind, sowie Schrauben 108, die zum Befestigen der als Grundplatte 105 ausgeführten Wandhalterung 100 an einer Flugzeugkabine 107 ausgeführt sind. Ferner ist eine an der Grundplatte 105 angebrachte Steckereinheit 104 dargestellt, die durch ein Führungsbolzen 109 an der Grundplatte 105 positioniert ist.

Fig. 7a zeigt ein Bediensystem 110 zum Bedienen von Bordunterhaltungseinheiten in einer Flugzeugkabine 107 mit einer Wandhalterung 100 und einer Bedieneinheit 101. Befestigungseinheiten 103, die als Haken ausgeführt sind, sind zum Führen der Bedieneinheit 101 bei einer Installation der Bedieneinheit 101 an der Wandhalterung 100 ausgeführt. Eine Steckereinheit 104 zum Bereitstellen einer Steckverbindung zwischen der Bedieneinheit 101 und der Wandhalterung 100 bei einer Installation der Bedieneinheit 101 an der Wandhalterung 100 sind hier nicht dargestellt, sollen jedoch in dem dargestellten Bediensystem 110 enthalten sein.

Ein Rahmen 114 ist auf der als Grundplatte 105 ausgeführten standardisierten Wandhalterung 100 durch Schnappverschlüsse 103 anbringbar. Der Rahmen 114 dient der Befestigung der Bedieneinheit 101.

Fig. 7b zeigt eine seitliche Schnittansicht des Rahmens 114 zum Befestigen der Bedieneinheit 101 durch Schnappverschlüsse 113, die es ermöglichen, dass der Rahmen 114 an der Grundplatte 105 anbringbar ist, wie in Fig. 7a gezeigt wird.

Fig. 7c zeigt eine seitliche Schnittansicht des Rahmens 114 mit Schnappverschlüssen 103 und einer Bedieneinheit 101 entlang der Schnittlinie B-B gemäß Fig. 7a.

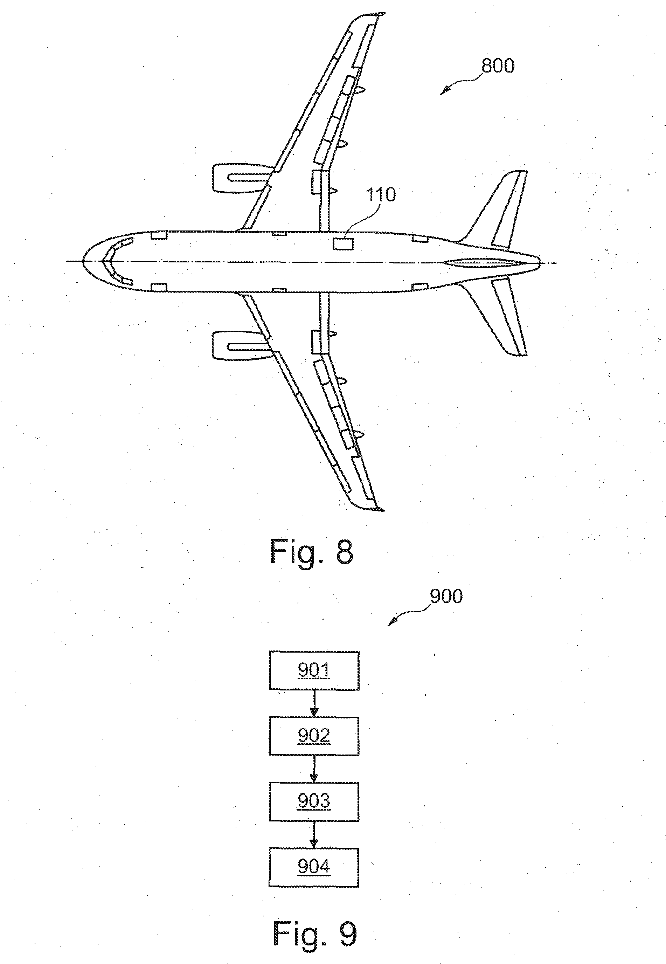

Fig. 8 zeigt eine schematische Darstellung eines Luftfahrzeugs 800 mit einem Bediensystem 110.

Fig. 9 zeigt ein Flussdiagramm eines Verfahrens 900 zum Befestigen einer Bedieneinheit 101 von Systemkomponenten in einer Flugzeugkabine 107 an einer Wand.

Das Verfahren 900 weist die folgenden Schritte auf: In Schritt 901 erfolgt das Positionieren der Bedieneinheit 101 in einer ersten Position relativ zu einer Wandhalterung. In Schritt 902 erfolgt dann das Führen der Bedieneinheit 101 durch eine Befestigungseinheit 103 der Wandhalterung 100 von der ersten Position in eine zweite Position. Schließlich wird dann in einem weiteren Schritt 903 eine Steckverbindung zwischen der Bedieneinheit 101 und der Wandhalterung 100 und eine Fixierung der Bedieneinheit 101 durch die Bewegung der Bedieneinheit 101 von der ersten Position in die zweite Position hergestellt. Im abschließenden Schritt 904 wird die Bedieneinheit 101 an der Wandhalterung 100 durch das Anbringen eines Rahmens 114 an die Wandhalterung 100 befestigt.

Obwohl die Erfindung unter Bezugnahme auf Ausführungsbeispiele beschrieben wurde, können verschiedene Änderungen und Modifikationen vorgenommen werden, ohne den Schutzbereich der Erfindung zu verlassen. Die standardisierte Wandhalterung gemäß der Erfindung können zum Installieren jeglicher Bedieneinheiten von Transportmitteln, wie Fahrzeugen, Flugzeugen, Helikoptern, Wasser- oder Schienenfahrzeugen an der Wandhalterung verwendet werden.

Ergänzend ist darauf hinzuweisen, dass "umfassend" oder "aufweisend" keine anderen Elemente oder Schritte ausschließt und "eine" oder "ein" keine Vielzahl ausschließt. Insbesondere kann die standardisierte Wandhalterung beispielsweise also mehr als eine Befestigungseinheit, mehr als eine Steckereinheit, mehr als eine Grundplatte, mehr als einen Führungsbolzen, mehr als ein Gewinde, mehr als einen Verkleidungsrahmen und mehr als einen Rahmen aufweisen.

Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Als Grundplatte (105) ausgeführte standardisierte Wandhalterung (100) für eine Bedieneinheit (101) von Systemkomponenten in einer Flugzeugkabine (107), wobei die Bedieneinheit (101) einen Stecker (117) und eine Hakenöse aufweist; die Wandhalterung (100) aufweisend:
eine Befestigungseinheit (103), die zum Aufnehmen der Hakenöse (116) der Bedieneinheit (101) ausgeführt ist und
wenigstens eine Steckereinheit (104), in die der Stecker (117) der Bedieneinheit (101) passt,
wobei die Befestigungseinheit (103) ein zentrierender Haken (103) ist;
wobei der zentrierende Haken (103) zum Führen der Bedieneinheit (101) bei einer Installationsbewegung der Bedieneinheit (101) an der Wandhalterung (100) ausgeführt ist; und
wobei die Steckereinheit (104) zum Bereitstellen einer Steckverbindung zwischen der Bedieneinheit (101) und der Wandhalterung (100) bei der Installationsbewegung der Bedieneinheit (101) an der Wandhalterung (100) ausgeführt ist.

2. Wandhalterung (100) nach Anspruch 1, weiterhin aufweisend:
eine Grundplatte (105);
wobei die Grundplatte (105) zur Anbringung der Wandhalterung (100) an der Flugzeugkabine (107) ausgeführt ist;
wobei die Steckereinheit (104) an die Grundplatte (105) montiert ist.

3. Wandhalterung (100) nach Anspruch 2,
wobei die Befestigungseinheit (103) an der Grundplatte (105) angebracht ist.

4. Wandhalterung (100) nach einem der vorhergehenden Ansprüche, weiterhin aufweisend:
wenigstens einen Führungsbolzen (109);
wobei die Steckereinheit (104) zur Positionierung der Steckereinheit (104) durch den Führungsbolzen (109) ausgeführt ist.

5. Wandhalterung (100) nach einem der Ansprüche 2 bis 4,
wobei die Steckereinheit (104) zum lösbaren Anbringen an der Grundplatte (105) ausgeführt ist.

6. Wandhalterung (100) nach einem der vorhergehenden Ansprüche, weiterhin aufweisend:
wenigstens ein Gewinde (111);
wobei das Gewinde (111) zum Befestigen der Bedieneinheit (101) an der Wandhalterung (100) ausgeführt ist.

7. Wandhalterung (100) nach Anspruch 6,
wobei das Gewinde (111) an der Grundplatte (105) angeordnet ist.

8. Wandhalterung (100) nach einem der vorhergehenden Ansprüche, weiterhin aufweisend:
einen Verkleidungsrahmen (102);
wobei der Verkleidungsrahmen (102) zum Verkleiden der Bedieneinheit (101) an der Bedieneinheit (101) mittels einer Schnappverbindung ausgeführt ist.

9. Wandhalterung (100) nach einem der vorhergehenden Ansprüche, weiterhin aufweisend:
einen Rahmen (114);
wobei der Rahmen (114) auf die Grundplatte (105) durch einen Schnappverschluss (113) anbringbar ausgeführt ist;
wobei der Rahmen (114) zum Befestigen der Bedieneinheit (101) ausgeführt ist;
wobei der Rahmen (114) zum Ausrichten der Bedieneinheit (101) in eine horizontale Richtung (H) und eine vertikale Richtung (V) ausgeführt ist, nachdem die Installationsbewegung der Bedieneinheit (101) durchgeführt ist.

10. Bedieneinheit (101) für Systemkomponenten in einer Flugzeugkabine (107) zur Installation an einer Wandhalterung (100) nach einem der vorhergehenden Ansprüche.

11. Bedieneinheit (101) nach Anspruch 10,
wobei die Bedieneinheit (101) unterhalb eines Monitors (115) der Bedieneinheit (101) zum Fixieren auf die Grundplatte (105) durch wenigstens eine Schraube ausgeführt ist.

12. Bediensystem (110) zum Bedienen von Bordunterhaltungseinheiten in einer Flugzeugkabine (107), das System (110) aufweisend:
eine Wandhalterung (100) nach einem der Ansprüche 1 bis 9;
eine Bedieneinheit (101) nach einem der Ansprüche 10 oder 11.

13. Luftfahrzeug (800) mit einem Bediensystem (110) nach Anspruch 12.

14. Verfahren (900) zum Befestigen einer Bedieneinheit (101) von Systemkomponenten in einer Flugzeugkabine (107) an einer Wand, das Verfahren aufweisend die Schritte:
Positionieren der Bedieneinheit (101) nach einem der Ansprüche 10 oder 11 in einer ersten Position relativ zu einer Wandhalterung (100, 901) nach einem der Ansprüche 1 bis 9;
Führen der Bedieneinheit (101) durch eine Befestigungseinheit (103) in Form eines zentrierenden Hakens (103) der Wandhalterung (100) von der ersten Position in eine zweite Position (902);
Herstellen einer Steckverbindung zwischen der Bedieneinheit (101) und der Wandhalterung (100) und einer Fixierung der Bedieneinheit (101) durch die Bewegung der Bedieneinheit (101) von der ersten Position in die zweite Position (903).

15. Verfahren (900) nach Anspruch 14, das Verfahren weiterhin aufweisend den Schritt:
Befestigen der Bedieneinheit (101) an der Wandhalterung (100) durch Anbringen eines Rahmens (114) an die Wandhalterung (100, 904).

## Claims

1. A standardised wall mounting (100) for a control unit (101) of system components in an aircraft cabin (107) designed as a base plate (105), wherein the control unit (101) comprises a plug (117) and a hook eye, the wall mounting (100) comprising:
a fastening unit (103) designed for receiving the hook eye (116) of the control unit (101), and
at least one plug unit (104) into which the plug (117) of the control unit (101) fits,
wherein the fastening unit (103) is a centering hook (103);
wherein the centering hook (103) is designed for guiding the control unit (101) during an installation movement of the control unit (101) on the wall mounting (100); and
wherein the plug unit (104) is designed for producing a plug connection between the control unit (101) and the wall mounting (100) during the installation movement of the control unit (101) on the wall mounting (100).

2. The wall mounting (100) of claim 1, further comprising:
a base plate (105);
wherein the base plate (105) is designed for installing the wall mounting (100) on the aircraft cabin (107); and
wherein the plug unit (104) is mounted on the base plate (105).

3. The wall mounting (100) of claim 2,
wherein the fastening unit (103) is mounted to the base plate (105).

4. The wall mounting (100) of one of the preceding claims, furthermore comprising:
at least one guide pin (109);
wherein the plug unit (104) is designed for positioning the plug unit (104) by means of the guide pin (109).

5. The wall mounting (100) of one of claims 2 to 4,
wherein the plug unit (104) is designed for being detachably mounted to the base plate (105).

6. The wall mounting (100) of one of the preceding claims, further comprising:
at least one thread (111);
wherein the thread (111) is designed for fastening the control unit (101) on the wall mounting (100).

7. The wal mounting (100) of claim 6,
wherein the thread (111) is arranged on the base plate (105).

8. The wall mounting (100) of one of the preceding claims, further comprising:
a cover frame (102);
wherein the cover frame (102) is designed on the control unit (101) by means of a snap-on connection in order to cover the control unit (101).

9. The wall mounting (100) of one of the preceding clalats, further comprising:
a frame (114);
wherein the frame (114) is designed such that it can be installed on the base plate (105) by means of a snap-on connection (113);
wherein the frame (114) is designed for fastening the control unit (101); and
wherein the frame (114) is designed for aligning the control unit (101) in a horizontal direction (H) and a vertical direction (V) after the installation movement of the control unit (101) has been carried out.

10. A control unit (101) for system components in an aircraft cabin (107) for being installed on a wall mounting (100) of one of the preceding claims.

11. The control unit (101) of claim 10,
wherein the control unit (101) is designed for being fixed on the base plate (105) underneath a monitor (115) of the control unit (101) by means of at least one screw.

12. A control system (110) for controlling in-flight entertainment units in an aircraft cabin (107), with the system (110) comprising:
a wall mounting (100) of one of claims 1 to 9;
a control unit (101) of one of claims 10 or 11.

13. An aircraft (800) with a control system (110) of claim 12.

14. A method (900) for fastening a control unit (101) of system components in an aircraft cabin (107) on a wall, with the method comprising the following steps:
positioning the control unit (101) of claim 10 or 11 in a first position relative to a wall mounting (100, 901) of one of the claims 1 to 9;
guiding the control unit (101) from the first position into a second position (902) by means of a fastening unit (103) in the form of a centering hook (103) of the wall mounting (100);
producing a plug connection between the control unit (101) and the wall mounting (100) and fixing the control unit (101) due to the movement of the control unit (101) from the first position into the second position (903).

15. The method (900) of claim 14, with the method furthermore comprising the following step:
fastening the control unit (101) on the wall mounting (100) by installing a frame (114) on the wall mounting (100, 904).

## Revendications

1. Support mural (100) standardisé réalisé en tant que plaque de base (105) pour une unité de commande (101) de composants de système dans une cabine d'aéronef (107), l'unité de commande (101) présentant une fiche (117) et un oeillet à crochet ; le support mural (100) présentant :
- une unité de fixation (103), qui est réalisée pour recevoir l'oeillet à crochet (116) de l'unité de commande (101) et
- au moins une unité d'enfichage (104), dans laquelle peut s'enficher la fiche (117) de l'unité de commande (101),
l'unité de fixation (103) étant un crochet de centrage (103) ;
le crochet de centrage (103) étant configuré pour guider l'unité de commande (101) lors d'un mouvement de montage de l'unité de commande (101) sur le support mural (100) ; et
l'unité enfichable (104) étant destinée à fournir une liaison par enfichage entre l'unité de commande (101) et le support mural (100) lors du mouvement d de montage de l'unité de commande (101) sur le support mural (100).

2. Support mural (100) selon la revendication 1, présentant en outre :
- une plaque de base (105) ;
la plaque de base (105) étant réalisée pour le montage du support mural (100) sur la cabine d'aéronef (107) ;
l'unité d'enfichage (104) étant montée sur la plaque de base (105).

3. Support mural (100) selon la revendication 2, l'unité de fixation (103) étant montée sur la plaque de base (105).

4. Support mural (100) selon l'une quelconque des revendications précédentes, présentant en outre :
- au moins une broche-guide (109) ;
l'unité d'enfichage (104) étant réalisée pour le positionnement de l'unité d'enfichage par l'intermédiaire de la broche-guide (109).

5. Support mural (100) selon l'une des revendications 2 à 4, l'unité d'enfichage (104) étant réalisée pour le montage amovible sur la plaque de base (105).

6. Support mural (100) selon l'une quelconque des revendications précédentes, présentant en outre :
- au moins un filetage (111) ;
le filetage (111) étant réalisé pour fixer l'unité de commande (101) au support mural (100).

7. Support mural (100) selon la revendication 6, le filetage (111) étant disposé sur la plaque de base (105).

8. Support mural (100) selon l'une quelconque des revendications précédentes, présentant en outre :
- un cadre de revêtement (102) ;
le cadre de revêtement (102) étant réalisé pour le revêtement de l'unité de commande (101) sur l'unité de commande (101) au moyen d'un raccord à cliquet (100).

9. Support mural (100) selon l'une quelconque des revendications précédentes, présentant en outre :
- un cadre (114) ;
le cadre (114) étant réalisé pour pouvoir être monté sur la plaque de base (105) par l'intermédiaire d'une fermeture à cliquet (113) ;
le cadre (114) étant réalisé pour fixer l'unité de commande (101) ;
le cadre (114) étant réalisé pour orienter l'unité de commande (101) dans une direction horizontale (H) et une direction verticale (V), après que le mouvement de montage de l'unité de commande (101) a été réalisé.

10. Unité de commande (101) pour des composants système dans une cabine d'aéronef (107) pour le montage sur un support mural (100) selon l'une des revendications précédentes.

11. Unité de commande (101) selon la revendication 10, l'unité de commande (101) étant réalisée sous un moniteur (115) de l'unité de commande (101) pour la fixation sur la plaque de base (105) à l'aide d'au moins une vis.

12. Système de commande (110) pour la commande d'unités de commande d'appareils de loisir de bord dans une cabine d'aéronef (107), le système (110) présentant :
- un support mural (100) selon l'une des revendications 1 à 9 ;
- une unité de commande (101) selon l'une des revendications 10 à 11.

13. Aéronef (800) comportant un système de commande (110) selon la revendication 12.

14. Procédé (900) pour la fixation d'une unité de commande (101) de composants de système dans une cabine d'aéronef (107) sur une paroi, le procédé comprenant les étapes de :
- positionnement de l'unité de commande (101) selon l'une des revendications 10 ou 11 dans une première position par rapport à un support mural (100, 901) selon l'une des revendications 1 à 9 ;
- guidage de l'unité de commande (101) par l'intermédiaire d'une unité de fixation (103) sous la forme d'un crochet de centrage (103) du support mural (100) de la première position à la seconde position (902) ;
- établissement d'une liaison par enfichage entre l'unité de commande (101) et le support mural (100) et d'une fixation de l'unité de commande (101) par l'intermédiaire du déplacement de l'unité de commande (101) de la première position à la seconde position (903).

15. Procédé (900) selon la revendication 14, le procédé présentant en outre l'étape suivante :
- fixation de l'unité de commande (101) au support mural (100) par l'intermédiaire du montage d'un cadre (114) sur le support mural (100, 904).
